Europäisches Patentamt

European Patent Office

Office européen des brevets

(19)

(11) Numéro de publication : **0 413 639 B1**

(12) **FASCICULE DE BREVET EUROPEEN**

(45) Date de publication du fascicule du brevet :
**08.06.94 Bulletin 94/23**

(51) Int. Cl.$^5$ : **G02B 7/00,** G02B 7/182

(21) Numéro de dépôt : **90402304.1**

(22) Date de dépôt : **16.08.90**

(54) **Assemblage de pièces faisant un angle entre elles et procédé d'obtention de cet assemblage.**

(30) Priorité : **18.08.89 FR 8911014**

(43) Date de publication de la demande :
**20.02.91 Bulletin 91/08**

(45) Mention de la délivrance du brevet :
**08.06.94 Bulletin 94/23**

(84) Etats contractants désignés :
**DE GB IT NL**

(56) Documents cités :
**WO-A-87/01509
DE-B- 2 653 650
GB-A- 2 136 145**

(73) Titulaire : **COMMISSARIAT A L'ENERGIE ATOMIQUE
31/33, rue de la Fédération
F-75015 Paris Cédex 15 (FR)**

(72) Inventeur : **Marion, François
102 Avenue de Karben
F-38120 Saint Egreve (FR)**
Inventeur : **Ravetto, Michel
Résidence Percevalière - B.P. 75
F-38170 Seyssinet Pariset (FR)**
Inventeur : **Tissot, Jean-Luc
3 Boulevard de Jomardière
F-38120 Saint Egreve (FR)**

(74) Mandataire : **Mongrédien, André et al
c/o BREVATOME
25, rue de Ponthieu
F-75008 Paris (FR)**

EP 0 413 639 B1

## Description

La présente invention concerne un assemblage de pièces faisant un angle entre elles ainsi qu'un procédé d'obtention de cet assemblage. Elle s'applique notamment à l'assemblage de très petites pièces planes, légères, devant former entre elles un angle faible et déterminé à l'avance, lorsque la précision de positionnement des pièces doit être grande et que l'assemblage doit être insensible aux vibrations.

Ainsi, l'invention s'applique par exemple à la fabrication d'un miroir qui résulte de l'assemblage d'un grand nombre de petites plaques planes qui font, avec un substrat, des angles déterminés pour obtenir ledit miroir.

On connaît déjà des techniques permettant d'obtenir un assemblage de pièces faisant un angle entre elles. Ces techniques sont les suivantes :

- La fixation par vis-écrou : le système vis-écrou permet le réglage de l'angle formé par deux pièces que l'on veut assembler mais en contre partie, l'assemblage obtenu est encombrant ; il nécessite, en plus des deux pièces, de nombreuses autres pièces qui augmentent le poids de l'assemblage en outre, cet assemblage peut subir des pertes de réglage (variation de l'angle entre les pièces) par suite de vibrations mécaniques auquel est généralement soumis un tel assemblage en cours d'utilisation où de stockage enfin, cette technique connue est limitée à des pièces dont les dimensions sont relativement importantes.

- Le collage avec une calle d'épaisseur, qui est interposée entre les deux pièces : un tel montage nécessite la réalisation de calles en forme de coins de très faible dimensions et donc très fagiles, puis un collage de l'ensemble calles-pièces, d'où des difficultés liées au positionnement au moment du collage et au déplacement d'une pièce par rapport à l'autre du fait du séchage ou de la polymérisation de la colle. On connaît également un procédé d'assemblage par soudure au moyen d'une calle d'épaisseur, voir le brevet DE-B-2 653 650.

On connaît également un procédé d'assemblage de composants électroniques au moyen d'éléments de soudure, notamment par la demande de brevet WO-A-87/01509. Cependant ce procédé connu conduit à un assemblage dans lequel les faces des composants électroniques, qui sont en regard l'une de l'autre, sont parallèles.

La présente invention vise un assemblage de pièces faisant un angle entre elles ainsi qu'un procédé d'obtention de cet assemblage, ce dernier ne présentant pas les inconvénients d'encombrement, de poids, de sensibilité aux vibrations et de déplacement relatif des pièces, inhérents aux techniques connues mentionnées plus haut.

De façon précise, la présente invention a tout d'abord pour objet un assemblage d'une première pièce et d'au moins une deuxième pièce donc une face est en regard d'une face de la première pièce et fait un angle avec celle-ci, assemblage caractérisé en ce que la face de la première pièce comprend au moins deux plots, en ce que la face de la deuxième pièce comprend des plots respectivement en regard de ceux de la première pièce, en ce que l'assemblage comprend en outre au moins deux éléments de soudure sensiblement en forme de sphère tronquée, qui relient respectivement les plots de la première pièce aux plots correspondants de la deuxième pièce, l'un des éléments ayant un volume supérieur au volume de l'autre élément, et en ce que les surfaces des plots sont mouillables par le matériau des éléments de soudure à l'état fondu, tandis que leur environnement ne l'est pas.

Selon un mode de réalisation particulier de l'assemblage objet de l'invention, cet assemblage comprend au moins une rangée d'éléments de soudure dont les volumes vont en augmentant d'une extrémité de la rangée à l'autre extrémité, chaque élément reliant un plot de la première pièce à un plot de la deuxième pièce.

Selon un autre mode de réalisation particulier, l'assemblage comprend une pluralité de rangées parallèles d'éléments de soudure et, dans chaque rangée, les éléments de soudure ont le même volume, ce volume allant en augmentant d'une rangée d'extrémité à l'autre rangée d'extrémité.

Dans une application de la présente invention, la première pièce est mobile en translation par rapport à un support muni d'une source de lumière et d'un détecteur de cette lumière et la deuxième pièce est apte à réfléchir cette lumière par son autre face, est située en regard de la source lumineuse et tournée vers le détecteur de façon à réfléchir la lumière vers celui-ci pour une position déterminée de la première pièce par rapport au support.

Dans une autre application, l'assemblage comprend une pluralité de deuxièmes pièces dont les autres faces sont optiquement réflectrices et qui sont fixées à la première pièce par des éléments de soudure de telle façon que les autres faces des deuxièmes pièces forment un miroir.

Dans une autre application, la première pièce porte également un dispositif d'optique intégrée et la deuxième pièce comporte un émetteur de lumière qui est prévu pour envoyer un faisceau lumineux en direction du dispositif d'optique intégrée.

La présente invention a également pour objet un procédé d'assemblage d'une première pièce et d'au moins une deuxième pièce dont une face est en regard d'une face de la première pièce et porte des plots destinés à être respectivement reliés à des plots portés par la face de la première pièce, au moyen d'éléments de soudure faits d'un matériau métallique à bas point de fusion, soudable aux plots, la surface de chaque plot étant mouillable par le matériau à l'état fondu a lors que son environnement ne l'est pas, ce procédé comprenant les étapes suivantes :

- chaque plot de la première pièce est recouvert d'une galette du matériau de soudure, qui s'étend sur l'environnement de ce plot, les galettes ayant une épaisseur sensiblement constante,
- les plots de la deuxième pièce sont placés sur les galettes correspondantes de la première pièce,
- les galettes sont portées à une température à laquelle elles sont à l'état fondu, ces galettes ayant des volumes différents qui, de même que l'épaisseur des ga lettes, les valeurs des surfaces des plots et l'écartement entre les plots, sont choisis pour que la face de la deuxième pièce fasse un angle déterminé avec la face de la première pièce lorsque les galettes sont portées à ladite température, et
- la température est ramenée au-dessous de la température de fusion du matériau de soudure.

Dans un mode de mise en oeuvre particulier du procédé objet de l'invention, la première pièce comprend au moins une rangée de plots et l'on forme sur ces plots des galettes dont les volumes vont en augmentant d'une extrémité de la rangée à l'autre extrémité et permettent l'obtention dudit angle.

Enfin, dans un autre mode de mise en oeuvre particulier, la première pièce comprend une pluralité de lignes parallèles de plots et, pour chaque ligne, on forme sur les plots de cette ligne des galettes de même volume, les volumes des galettes allant en augmentant d'une ligne d'extrémité à l'autre ligne d'extrémité et permettant l'obtention dudit angle.

La présente invention sera mieux comprise à la lecture de la description suivante, donnée à titre purement indicatif et nullement limitatif en faisant référence aux dessins annexés sur lesquels :

- les figures 1A et 1B illustrent schématiquement un procédé conforme à l'invention, permettant l'assemblage de deux pièces au moyen de deux éléments de soudure, la figure 1A montrant les deux pièces avant leur assemblage et la figure 1B montrant l'assemblage obtenu,
- les figures 2A à 2C illustrent schématiquement une application de l'invention à la réalisation d'un détecteur de proximité,
- les figures 3A, 3B et 4A, 4B illustrent schématiquement une autre application de l'invention à la fabrication de miroirs,
- la figure 5 illustre schématiquement une autre application de l'invention au couplage d'une source lumineuse à un dispositif d'optique intégrée,
- les figures 6A et 6B illustrent schématiquement un procédé conforme à l'invention, permettant l'assemblage de pièces de longueur importante, et
- la figure 7 illustre schématiquement un procédé conforme à l'invention, permettant l'assemblage de pièces de largeur importante.

Dans la présente invention, on utilise des éléments de soudure faits d'un matériau dont la température de fusion est suffisamment faible pour ne pas détériorer les pièces lors de l'assemblage de celles-ci conformément à l'invention. Le matériau peut être choisi dans le groupe comprenant l'étain, l'indium, le plomb et les alliages métalliques à bas point de fusion, contenant de l'étain, de l'indium ou du plomb.

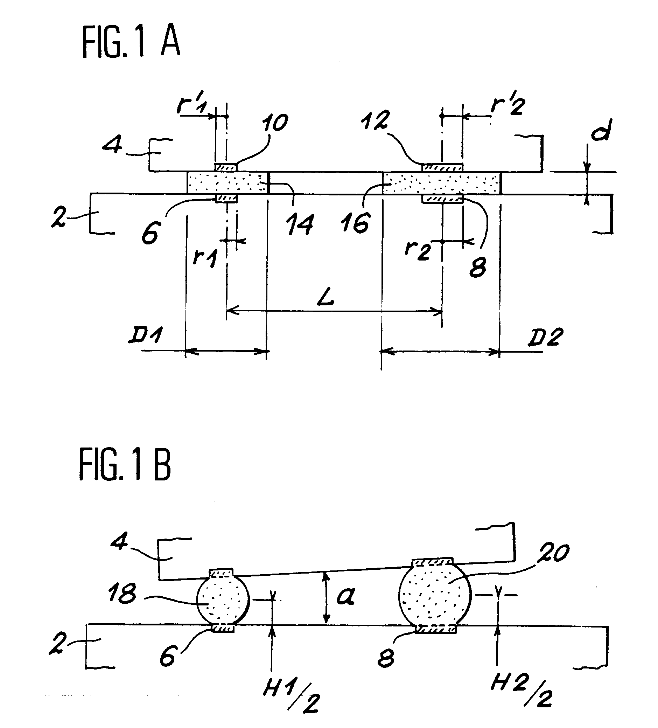

Les figures 1A et 1B illustrent schématique un procédé conforme à l'invention, permettant d'assembler deux pièces 2 et 4. Il s'agit par exemple de plaques faites d'un matériau semi-conducteur tel que le silicium. La pièce 2 porte des plots 6 et 8 par exemple circulaires dont les axes présentent un écartement L. De même, la pièce 4 porte des plots 10 et 12 par exemple circulaire, dont les axes présentent également un écartement L et qui sont destinés à être respectivement reliés aux plots 6 et 8. Ces plots sont métalliques, par exemple en or, métal qui est mouillable par un matériau tel que l'indium à l'état fondu. En revanche, sur chaque pièce, l' environnement de chaque plot est par exemple en silice, non mouillable par ledit matériau à l'état fondu.

On forme respectivement sur les plots 6 et 8 de la pièce 2 des galettes d'indium 14 et .16 de forme par exemple cylindrique et de même épaisseur d, de telle façon que chaque galette recouvre le plot qui lui est associé et déborde de ce plot de façon à recouvrir également une partie non mouillable de la pièce 2, partie qui entoure le plot en question.

Les galettes 14 et 16 ont donc des diamètres respectifs D1 et D2 tels que D1 soit supérieur au double du rayon r1 du plot 6 et que D2 soit supérieur au double du rayon r2 du plot 8.

De plus, ces ga lettes sont telles que D1 soit supérieur au double du rayon r'1 du plot 10 de la pièce 4 et que D2 soit supérieur au double du rayon r'2 du plot 12 de cette pièce 4.

Les volumes des galettes 14 et 16 sont différents et, comme on le verra mieux par la suite, sont déterminés, ainsi que les paramètres L, d, r1, r2, r'1 et r'2 de façon que, lorsque l'assemblage est réalisé (figure 1B), les faces des pièces 2 et 4, qui sont en regard l'une de l'autre, fassent entre elles un angle a déterminé à l'avance.

Une fois les galettes formées, on dispose la pièce 4 sur la pièce 2 de façon que le plot 10 vienne au contact de la galette 14 et que le plot 12 vienne au contact de la galette 16.

Les galettes de métal de soudure et les plots (plots dont les surfaces respectives sont, dans l' exemple donné, dans le même plan que les surfaces de l'environnement desdits plots) sont obtenus par des techniques classiques dans le domaine de la microélectronique (insolation de résine photosensible puis gravure).

Ainsi la précision de l'assemblage à réaliser est-elle sensiblement égale à la précision obtenue avec de telles techniques.

A titre d'exemple, les galettes sont formées en déposant d'abord une couche continue d'épaisseur d d'indium sur la surface de la pièce 2 puis en plaçant au-dessus des endroits où l'on veut réaliser les galettes des masques empêchant la gravure de la couche en ces endroits, après quoi une gravure par attaque chimique locale des parties non masquées laisse seulement subsister les galettes 14 et 16, l'attaque chimique étant arrêtée lorsque la surface de la pièce 2 est atteinte.

Après avoir aligné les deux faces des pièces 2 et 4 et donc mis les plots 10 et 12 en contact avec les galettes 14 et 16 correspondantes, le métal de soudure (l'indium dans l'exemple donné) est porté à une température supérieure ou égale à sa température de fusion.

Du fait de la tension superficielle, le métal, qui est alors liquide, se rassemble en gouttes sphériques tronquées qui portent les références 18 et 20 sur la figure 1B et sont respectivement associées aux galettes 14 et 16. On notera que chaque goutte est seulement en contact avec les deux plots lui correspondant.

Les troncatures des gouttes sphériques sont dûes au contact entre ces gouttes de métal liquide et les surfaces mouillables des plots. La distance entre ces troncatures dépend du diamètre de la goutte de métal liquide correspondante ainsi que des diamètres des surfaces mouillables en regard.

En conséquence, en faisant varier ces paramètres, on peut faire varier la distance entre les surfaces mouillables en regard l'une de l'autre.

Il est donc possible, en utilisant deux gouttes sphériques de diamètres différents (résultant de galettes de diamètres différents) d'obtenir un assemblage de deux pièces faisant entre elle un angle a directement lié aux caractéristiques géométriques des gouttes sphériques comme on le voit sur la figure 1B.

Une fois l'assemblage obtenu, il est refroidi au-dessous de la température de fusion du métal de soudure.

On a indiqué que les gouttes étaient sphériques. En fait, les volumes obtenus sont des sphères légèrement déformées. En effet, lors de la fusion, le métal liquide, qui tend à prendre une forme sphérique par tension superficielle, est soumis à d'autres forces qui peuvent légèrement modifier sa forme.

Le procédé objet de l'invention est avantageusement utilisable dans le cas de montages de petits miroirs dans des emplacements restreints, ces miroirs étant susceptibles d'être soumis à des accélérations importantes.

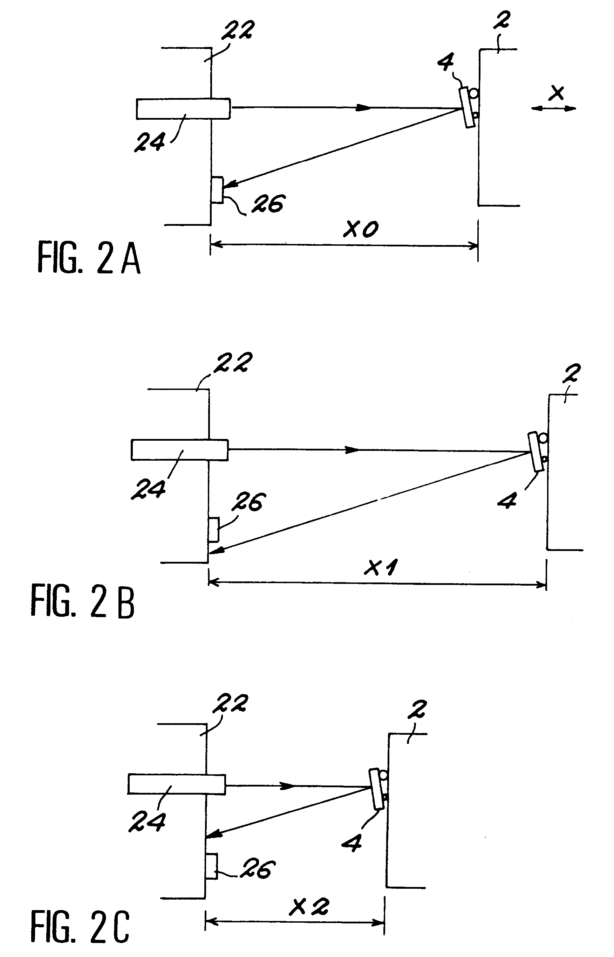

Ainsi, l'invention s'applique par exemple à la réalisation d'un détecteur de proximité comme on le voit sur les figures 2A à 2C. La pièce 2 est déplaçable en translation parallèlement à un axe X, par rapport à un support 22 qui porte une source lumineuse ponctuelle 24 apte à émettre un faisceau lumineux parallèle à l'axe X, et un photo-détecteur 26 apte à fournir un signal lorsqu'il reçoit un faisceau de ladite lumière.

La pièce 4 est apte à réfléchir cette lumière par son autre face (qui n'est pas en regard de la pièce 2) et est fixée sur cette pièce 2 de façon à se trouver en regard de la source 24 de sorte qu'elle reçoit le faisceau issu de cette source, l'inclinaison de la pièce 4 par rapport à la pièce 2 étant telle que le faisceau réfléchi par la pièce 4 se propage en direction de la zone du support 22 dans laquelle se trouve le photo-détecteur 26.

Ainsi, il existe une position de la pièce 2 par rapport au support 22, position pour laquelle le photo-détecteur reçoit effectivement le faisceau réfléchi par la pièce 4 et cette position correspond à une distance X0 entre la pièce 2 et le support 22 (figure 2A).

En revanche, pour d'autres positions, lorsque la distance entre la pièce 2 et le support 22 prend une valeur X1>X0 (figure 2B) où une valeur X2<X0 (figure 2C), le faisceau lumineux réfléchi par la pièce 4 n'atteint pas le photo-détecteur 26.

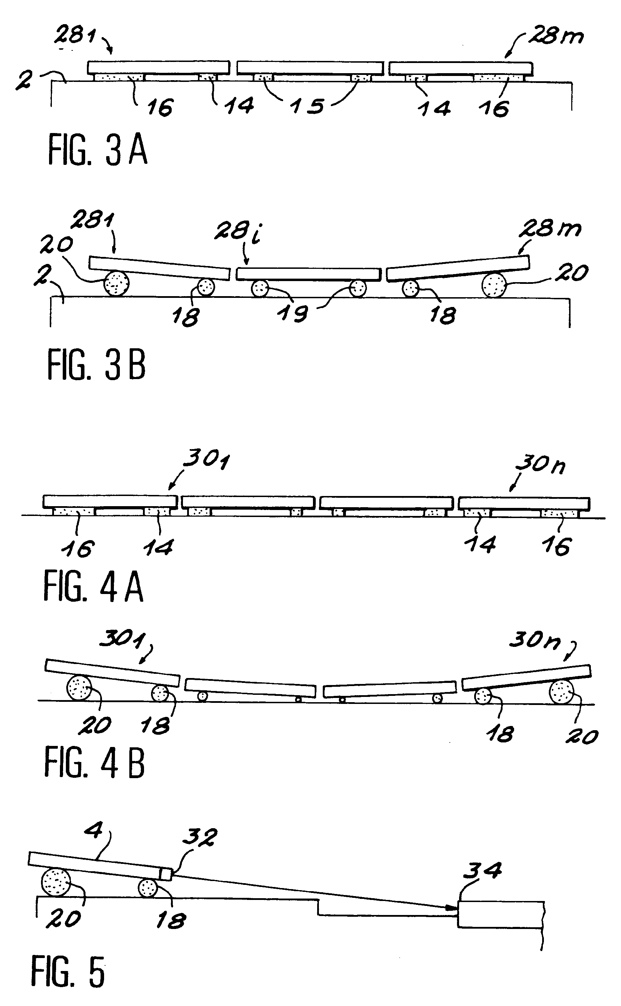

Les figures 3A, 3B et 4A, 4B illustrent schématiquement une autre application importante de la présente invention, à savoir la réalisation d'un miroir qui peut être concave, comme on le voit sur ces figures (mais qui pourrait également être convexe), par assemblage d'un grand nombre de seconde pièce $28_1 \ldots 28_m$ (figures 3A et 3B) ou $30_1 \ldots 30_n$ (figures 4A et 4B) sur une même première pièce 2, l'assemblage des secondes pièces sur la première pièce étant réalisé comme on l'a expliqué en se référant aux figures 1A et 1B. Chacune des secondes pièces est une plaque dont la face qui n'est pas en regard de la pièce 2, est optiquement réflectrice.

Les différents paramètres mentionnés plus haut sont alors déterminés pour que les faces respectives de chaque seconde pièce et de la première pièce, qui sont en regard l'une de l'autre, fassent entre elles un angle déterminé permettant l'obtention du miroir concave (ou convexe) voulu.

Sur les figures 3A, 3B et 4A, 4B les divers plots ne sont pas représentés mais on a représenté les galettes associées aux secondes pièces (figures 3A, 4A) et les divers éléments de soudures 18, 20 obtenus lorsque les miroirs élémentaires constitués par les secondes pièces ont été formés.

Le réglage collectif et simultané de ces miroirs élémentaires, réglage qui est obtenu par la variation du volume des liaisons métalliques réalisées conformément à l'invention, permet d'éviter un travail difficile et fastidieux qu'il fallait accomplir dans l'art antérieur, où l'on devait régler les miroirs élémentaires les uns après les autres. En effet, comme on l'a déjà indiqué, le procédé objet de l'invention permet d'obtenir facilement les angles désirés entre les miroirs élémentaires et leur substrat commun (première pièce 2), en calculant au préalable le volume de chacune des liaisons par éléments de soudure.

On notera que le miroir représenté sur la figure 3B possède un plan (ou un axe) de symétrie qui rencontre l'un des mi roi rs élémentaires, référencé $28_i$, ce dernier étant associé à deux éléments de soudure 19 de même volume, contrairement aux autres éléments de soudure. Les éléments de soudure 19 sont réalisés à partir de deux galettes 15 également de même volume (figure 3A) et le miroir élémentaire $28_i$ correspondant fait ainsi un angle nul avec le substrat 2 (ce qui n'est pas le cas avec les autres miroirs élémentaires).

La figure 5 illustre schématiquement une autre application importante de l'invention, à savoir le couplage d'une source lumineuse tel le qu'une diode émettrice 32, portée par le seconde pièce 4, à un dispositif d'optique intégrée 34 porté par la pièce 2. La pièce 4 est alors inclinée et orientée de façon que le faisceau lumineux issu de la source 32 en fonctionnement atteigne le dispositif d'optique intégrée 34 et y soit injecté.

En outre, l'alimentation électrique de la source 32 peut être effectuée par l'intermédiaire des éléments de soudures 18 et 20. A cet effet, on réalise sur les pièces 2 et 4, qui peuvent être des substrats semiconducteurs, des connexions électriques appropriées permettant l'amenée du courant électrique aux plots (non représentés) de la pièce 2 et l'amenée de courant électrique depuis les plots (non représentés) de la pièce 4 jusqu'à la source 32, les connexions étant réalisées par les techniques de la micro-électroniques.

A titre purement indicatif et nullement limitatif, le procédé décrit en se référant aux figures 1A et 1B s'applique au montage d'au moins une pièce 4 de forme parallélépipédique, d'épaisseur de l'ordre de 500μm, de longueur de l'ordre de 100μm et de largeur de l'ordre de 500μm,le poids de la pièce 4 étant de l'ordre de 1mg et les dimensions de la pièce 2 qui supporte la pièce 4 étant prévues en conséquence.

En d'autres termes, le procédé décrit en se référant aux figures 1A et 1B s'applique particulièrement au montage d'au moins une pièce légère et de faibles dimensions sur une autre pièce. On peut alors utiliser seulement deux éléments de soudure pour réaliser l'assemblage.

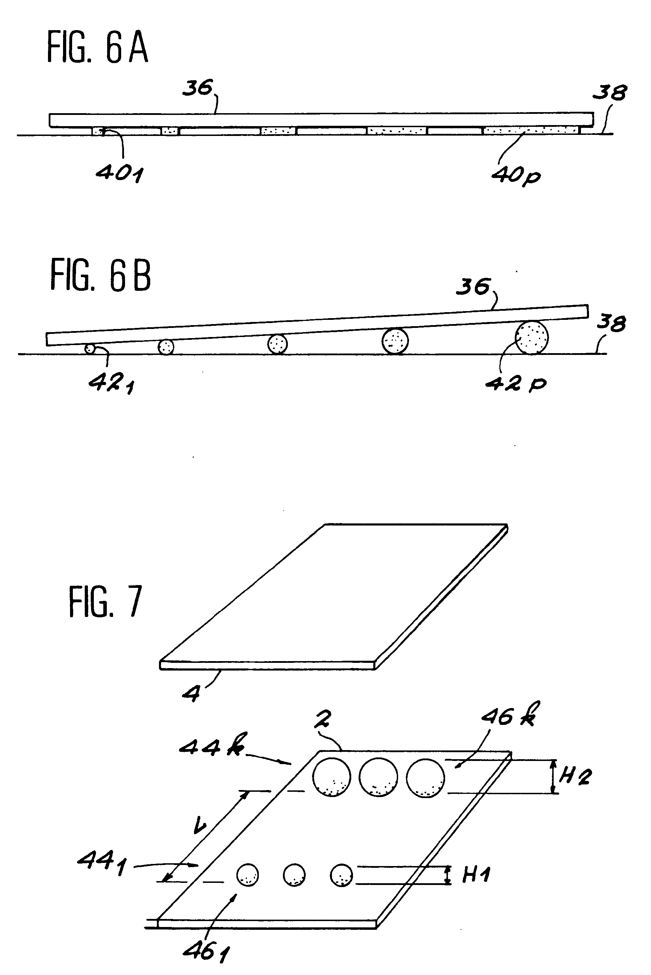

En revanche, lorsqu'on veut monter une pièce 36 de forme parallélépipédique de plus grande longueur (figure 6A) sur une pièce 38 de dimensions appropriées, on utilise de préférence une rangée de plusieurs galettes $40_1$ ... $40_p$, les différents paramètres

menti onnés plus haut, et parmi ceux-ci les volumes des galettes $40_1$ à $40_p$, étant calculés pour obtenir un assemblage (figure 6B) dans lequel la pièce 36 fait avec la pièce 38 un angle déterminé à l'avance. Alors, les volumes des éléments de soudure $42_1$ ... $42_p$ correspondant respectivement aux galettes $40_1$ ... $40_p$ vont en croissant d'une extrémité à l'autre de la rangée (les divers plots ne sont pas représentés).

Dans le cas de pièces 2 et 4 de grande largeur (figure 7), il peut être nécessaire d'utiliser, non pas une seule rangée d'au mois deux éléments de soudure, mais une pluralité de telles rangées adjacentes. Comme on le voit sur la figure 7, sur laquelle l'assemblage est représenté en supposant qu'on a écarté la pièce 4 de la pièce 2, on a alors une pluralité de lignes parallèles $44_1$ ... $44_k$, par exemple deux lignes séparées d'une distance L, chaque ligne $44_1$ ... $44_k$ comportant une pluralité d'éléments de soudure $46_1$ ... $46_k$ de même volume, les volumes allant en croissant d'une ligne d'extrémité $44_1$ jusqu'à l'autre ligne d'extrémité $44_k$ et étant comme précédemment déterminés, avec les autres paramètres, pour obtenir l'angle voulu entre les deux pièces 2 et 4.

Pour la clarté de la figure 7, les diverses lignes de plots des pièces 2 et 4, lignes homologues des lignes $44_1$ à $44_k$ ne sont pas représentées, de même qu'on n 'a pas représenté les diverses ga lettes conduisant aux éléments de soudure $46_1$ à $46_k$.

En revenant aux figures 1A et 1B, on va maintenant expliquer la détermination des différents paramètres permettant d'aboutir à l'angle a déterminé à l'avance.

En considérant sur la figure 1B le dièdre formé par les faces des pièces 2 et 4, qui sont en regard l'une de l'autre, et le plan bissecteur de ce dièdre, l'axe du plot 6, (supposé circulaire) rencontre ce plan bissecteur en un point dont la distance à la surface mouillable du plot 6 est notée H1/2 (moitié d'une longueur notée H1). De même, l'axe du plot 8 (également supposé circulaire) rencontre le plan bissecteur en un point dont la distance à la surface mouillable du plot 8 est notée H2/2 (moitié d'une longueur notée H2).

On peut écrire :

$$H1^3/6 + H1(r'1^2 + r1^2)/2 - d.D1^2 = 0 \quad (1)$$
$$H2^3/6 + H2(r'2^2 + r2^2)/2 - d.D2^2 = 0 \quad (2)$$

Chacun des nombres H1 et H2 est solution d'une équation du troisième degré avec les conditions suivantes :

$$0 < H1 < (6\ d.D1^2)^{1/3}$$
$$0 < H2 < (6\ d.D2^2)^{1/3}$$

En outre, H1 et H2 doivent être positifs et inférieurs aux diamètres respectifs des sphères non tronquées correspondantes.

On peut également écrire :

$$(H2 - H1)/2L = tg(a/2)$$

A titre d'exemple, en supposant r'1=r1=5 micromètres, D1=20 micromètres, d=6 micromètres, r'2=r2=7 micromètres, D2=30 micromètres, on obtient H1=22,3 micromètres et H2=28,8 micromètres et, pour L=100 micromètres, l'angle a est égal à 3,7 degrés.

Dans la pratique, on désire assembler des pièces de dimensions connues avec un angle "a" déterminé. Pour ce faire, dans un premier temps, on détermine les diamètres et les positions des galettes d'indium qui sont compatibles avec les dimensions des pièces à assembler. A titre d'exemple, si la plus petite des deux pièces a une longueur de 150 micromètres, la distance L entre les centres des surfaces mouillables peut être prise égale à 100 micromètres. On notera que L doit être supérieur à D1+D2. Connaissant L, on peut donc déterminer H2-H1. On peut ensuite déterminer les diamètres des surfaces mouillables de telle façon que l'accrochage mécanique des pièces soit suffisant pour maintenir celles-ci. On notera que D1 doit être supérieur à 2r1 et à 2r'1, que D2 doit être supérieur à 2r2 et à 2r'2 et que D1+D2 doit être inférieur à la largeur et à la longueur des pièces (dans le cas où celles-ci sont rectangulaires).

En choisissant d, r1, r2, r'1, r'2 et H1 (ce qui permet de calculer H2) on peut déterminer D1 et D2 en utilisant les formules (1) et (2).

Alors, si les valeurs trouvées pour D1 et D2 ne respectent pas les inégalités mentionnées, on change la valeur de L et éventuellement celle de H1 ou d'autres paramètres, ce qui permet de calculer d'autres valeurs pour D1 et D2 et l'on procède ainsi jusqu'à ce que toutes les inégalités relatives à l'assemblage soient satisfaites pour obtenir l'angle "a" choisi.

## Revendications

1. Assemblage d'une première pièce (2; 38) et d'au moins une deuxième pièce (4; $28_1$ ... $28_m$; $30_1$ ... $30_n$ ; 36) dont une face est en regard d'une face de la première pièce et fait un angle (a) avec celle-ci, assemblage caractérisé en ce que la face de la première pièce comprend au moins deux plots (6, 8), en ce que la face de la deuxième pièce comprend des plots (10, 12) respectivement en regard de ceux de la première pièce, en ce que l' assemblage comprend en outre au moins deux éléments de soudure (18, 20; $42_1$ ... $42_p$; $46_1$ ... $46_k$) sensiblement en forme de sphère tronquée, qui relient respectivement les plots de la première pièce aux plots correspondants de la deuxième pièce, l'un des éléments ($20;42_p;46_k$) ayant un volume supérieur au volume de l'autre élément ($18;42_1;46_1$), et en ce que les surfaces des plots sont mouillables par le matériau des éléments de soudure à l'état fondu, tandis que leur environnement ne l'est pas.

2. Assemblage selon la revendication 1, caractérisé en ce qu'il comprend au moins une rangée d'éléments de soudure ($42_1$ ... $42_p$) dont les volumes vont en augmentant d'une extrémité de la rangée à l'autre extrémité, chaque élément reliant un plot de la première pièce à un plot de la deuxième pièce.

3. Assemblage selon la revendication 1, caractérisé en ce qu'il comprend une pluralité de rangées parallèles ($44_1$ ... $44_k$) d'éléments de soudure et en ce que, dans chaque rangée, les éléments de soudure ($46_1$ ... $46_k$) ont le même volume, ce volume allant en augmentant d'une rangée d'extrémité à l'autre rangée d'extrémité.

4. Assemblage selon l'une quelconque des revendications 1 à 3, caractérisé en ce que la première pièce (2) est mobile en translation par rapport à un support (22) muni d'une source de lumière (24) et d'un détecteur (26) de cette lumière et en ce que la deuxième pièce (4) est apte à réfléchir cette lumière par son autre face, est située en regard de la source lumineuse et tournée vers le détecteur de façon à réfléchir la lumière vers celui-ci pour une position déterminée de la première pièce par rapport au support.

5. Assemblage selon l'une quelconque des revendications 1 à 3, caractérisé en ce qu'il comprend une pluralité de deuxièmes pièces ($28_1$ ... $28_m$; $30_1$ ... $30_n$) dont les autres faces sont optiquement réflectrices et qui sont fixées à la première pièce (2) par des éléments de soudure de tel le façon que les autres faces des deuxièmes pièces forment un miroir.

6. Assemblage selon l'une quelconque des revendications 1 à 3, caractérisé en ce que la première pièce (2) porte également un dispositif d'optique intégrée (34) et en ce que la deuxième pièce (4) comporte un émetteur de lumière (32) qui est prévu pour envoyer un faisceau lumineux en direction du dispositif d'optique intégrée.

7. Procédé d'assemblage d'une première pièce (2; 38) et d'au moins une deuxième pièce (4; $28_1$ ... $28_m$; $30_1$ ... $30_n$; 36) dont une face est en regard d'une face de la première pièce et porte des plots (10, 12) destinés à être respectivement reliés à des plots (6, 8) portés par la face de la première pièce, au moyen d'éléments de soudure faits d'un matériau métallique à bas point de fusion, soudable aux plots, la surface de chaque plot étant mouillable par le matériau à l'état fondu a lors que son environnement ne l'est pas, ce procédé comprenant les étapes suivantes :
   - chaque plot de la première pièce est recouvert d'une galette (14, 16; $28_1$ ... $28_m$; $40_1$ ... $40_p$) du matériau de soudure, qui s'étend sur l'environnement de ce plot, les galettes ayant une épaisseur sensiblement constante,

- les plots de la deuxième pièce sont placés sur les galettes correspondantes de la première pièce,
- les galettes sont portées à une température à laquelle elles sont à l'état fondu, ces galettes ayant des volumes différents qui, de même que l'épaisseur des galettes, les valeurs des surfaces des plots et l'écartement entre les plots, sont choisis pour que la face de la deuxième pièce fasse un angle déterminé (a) avec la face de la première pièce lorsque les galettes sont portées à ladite température, et
- la température est ramenée au-dessous de la température de fusion du matériau de soudure.

8. Procédé selon la revendication 7, caractérisé en ce que la première pièce (38) comprend au moins une rangée de plots et en ce que l'on forme sur ces plots des galettes ($40_1$ ... $40_p$) dont les volumes vont en augmentant d'une extrémité de la rangée à l'autre extrémité et permettent l'obtention dudit angle.

9. Procédé selon la revendication 7, caractérisé en ce que la première pièce (2) comprend une pluralité de lignes parallèles ($44_1$ ... $44_k$) de plots et en ce que, pour chaque ligne, on forme sur les plots de cette ligne des galettes de même volume, les volumes des galettes allant en augmentant d'une ligne d'extrémité à l'autre ligne d'extrémité et permettant l'obtention dudit angle.

**Patentansprüche**

1. Zusammenbau eines ersten Teils (2; 38) und wenigstens eines zweiten Teils (4; $28_1$ ... $28_m$; $30_1$ ... $30_n$; 36), von dem eine Fläche einer Fläche des ersten Teils gegenübersteht und einen Winkel ($\alpha$) mit dieser bildet, **dadurch gekennzeichnet,** daß die Fläche des ersten Teils wenigstens zwei Metallstücke (6, 8) enthält, dadurch, daß die Fläche des zweiten Teils Metallstücke (10, 12) enthält, jeweils denen der ersten Fläche gegenüberstehend, dadurch, daß der Zusammenbau außerdem wenigstens zwei Lötelemente umfaßt (18, 20; $42_1$ ... $42_p$; $46_1$ ... $46_k$), im wesentlichen mit der Form einer abgestumpften Kugel, die die Metallstücke des ersten Teils mit den entsprechenden Metallstücke des zweiten Teils verbinden, wobei eines der Elemente (20; $42_p$; $46_k$) ein größeres Volumen hat als das andere Element (18;

$42_1$; $46_1$), und dadurch, daß die Oberflächen der Metallstücke benetzbar sind durch das Material der Lötelemente im geschmolzenen Zustand, während ihre Umgebung es nicht ist.

2. Zusammenbau nach Anspruch 1, dadurch gekennzeichnet, daß er wenigstens eine Reihe von Lötelementen umfaßt ($42_1$ ... $42_p$), deren Volumen zunehmen von einem Ende der Reihe zum anderen Ende, wobei jedes Element ein Metallstück des ersten Teils mit einem Metallstück des zweiten Teils verbindet.

3. Zusammenbau nach Anspruch 1, dadurch gekennzeichnet, daß er eine Vielzahl von parallelen Reihen ($44_1$ ... $44_k$) von Lötelementen umfaßt und dadurch, daß in jeder Reihe die Lötelemente ($46_1$ ... $46_k$) dasselbe Volumen haben, wobei dieses Volumen zunimmt von einer Endreihe zu der anderen Endreihe.

4. Zusammenbau nach einem der Ansprüche 1 bis 3, dadurch gekennzeichnet, daß das erste Teil (2) beweglich ist in Längsrichtung bezüglich eines Trägers (22), der mit einer Lichtquelle (24) und einem Detektor (26) dieses Licht versehen ist, und dadurch, daß das zweite Teil (4) imstande ist, dieses Licht mit seiner anderen Fläche zu reflektieren, sich der Lichtquelle gegenüber befindet und so gegen den Detektor gedreht ist, daß sie für eine bestimmte Position des ersten Teils, bezogen auf den Träger, das Licht auf diesen reflektiert.

5. Zusammenbau nach einem der Ansprüche 1 bis 3, dadurch gekennzeichnet, daß er eine Vielzahl von zweiten Teilen umfaßt ($28_1$ ... $28_m$; $30_1$ ... $30_n$) deren andere Flächen optisch reflektierend sind und so durch Lötelemente an dem ersten Teil (2) befestigt sind, daß die anderen Flächen der zweiten Teile einen Spiegel bilden.

6. Zusammenbau nach einem der Ansprüche 1 bis 3, dadurch gekennzeichnet, daß das erste Teil (2) ebenfalls eine integriertoptische Einrichtung (34) trägt und dadurch, daß das zweite Teil (4) einen Lichtemitter (32) enthält, der vorgesehen ist, ein Lichtbündel in Richtung der integriert-optischen Einrichtung zu senden.

7. Zusammenbauverfahren eines ersten Teils (2; 38) und wenigstens eines zweiten Teils (4; $28_1$ ... $28_m$; $30_1$ ... $30_n$; 36), von dem eine Fläche einer Fläche eines zweiten Teils gegenübersteht und Metallstücke (10, 12) enthält, dazu bestimmt, jeweils verbunden zu werden mit Metallstücken (6, 8), enthalten in der Fläche des ersten Teils, mittels Lötelementen, hergestellt aus einem metallischen Material mit niedrigem Schmelzpunkt, verlötbar mit den Metallstücken, wobei die Oberfläche jedes Metallstücks benetzbar ist durch das Material in geschmolzenem Zustand, wohingegen seine Umgebung es nicht ist, wobei dieses Verfahren die folgenden Schritte umfaßt:

- jedes Metallstück des ersten Teils wird bedeckt mit einem Batzen (14, 16; $28_1 \dots 28_m$; $40_1 \dots 40_p$) Lötmaterial, der sich über die Umgebung dieses Metallstücks erstreckt, wobei die Batzen eine im wesentlichen konstante Dicke aufweisen,
- die Metallstücke des zweiten Teils werden auf den entsprechenden Batzen des ersten Teils angeordnet,
- die Batzen werden auf eine Temperatur gebracht, bei der sie im geschmolzenen Zustand sind, wobei diese Batzen unterschiedliche Volumen haben, die ebenso wie die Dicke der Batzen so gewählt werden, daß die Fläche des zweiten Teils mit der Fläche des ersten Teils einen bestimmten Winkel ($\alpha$) bildet, wenn die Batzen auf die genannte Tempertur gebracht worden sind, und
- die Temperatur wird zurückgeführt unter die Schmelztemperatur des Lötmaterials.

8. Verfahren nach Anspruch 7, dadurch gekennzeichnet, daß das erste Teil (38) wenigstens eine Reihe Metallstücke umfaßt, und daß man auf diesen Metallstücken Batzen ($40_1 \dots 40_p$) bildet, deren Volumen zunehmen von einem Ende der Reihe zum anderen Ende und die Herstellung des genannten Winkels ermöglichen.

9. Verfahren nach Anspruch 7, dadurch gekennzeichnet, daß das erste Teil (2) eine Vielzahl paralleler Zeilen ($44_1 \dots 44_k$) von Metallstücken umfaßt und dadurch, daß man, für jede Zeile, auf den Metallstücken dieser Zeile Batzen gleichen Volumens bildet, wobei die Volumen der Batzen zunehmen von einer Endzeile zur anderen Endzeile und die Herstellung des genannten Winkels ermöglichen.

**Claims**

1. Assembly of a first part (2; 38) and at least one second part (4; $28_1 \dots 28_m$; $30_1 \dots 30_n$; 36), whereof one face faces a face of the first part and forms an angle (a) therewith, characterized in that the face of the first part comprises at least two contact studs (6, 8), in that the face of the second part comprises contact studs (10, 12) respectively facing those of the first part, in that the assembly also comprises at least two welding elements (18, 20; $42_1 \dots 42_p$; $46_1 \dots 46_k$) essentially shaped like a truncated sphere, which respectively connect the contact studs of the first part to the corresponding contact studs of the second part, one of the elements (20; $42_p$; $46_k$) having a volume larger than that of the other element (18; $42_i$; $46_i$) and in that the surfaces of the contact studs are wettable by the material of the welding elements in the molten state, whereas their environment is not.

2. Assembly according to claim 1, characterized in that it comprises at least one row of welding elements ($42_1 \dots 42_p$), whose volumes increase from one end of the row to the other, each element connecting a stud of the first part to a stud of the second part.

3. Assembly according to claim 1, characterized in that it comprises a plurality of parallel rows ($44_1 \dots 44_k$) of welding elements and in that, in each row, the welding elements ($46_1 \dots 44_k$) have the same volume, which increases from one end row to the other.

4. Assembly according to any one of the claims 1 to 3, characterized in that the first part (2) is mobile in translation with respect to a support (22) provided with a light source (24) and a detector (26) of said light and in that the second part (4) is able to reflect said light by its other face and is located facing the light source and turned towards the detector in such a way that it reflects the light towards the latter for a given position of the first part with respect to the support.

5. Assembly according to any one of the claims 1 to 3, characterized in that it comprises a plurality of second parts ($28_1 \dots 28_m$; $30_1 \dots 30_n$), whose other faces are optically reflecting and which are fixed to the first part (2) by welding elements, in such a way that the other faces of the second parts form a mirror.

6. Assembly according to any one of the claims 1 to 3, characterized in that the first part (2) also carries an integrated optical device (34) and in that the second part (4) has a light emitter (32), which supplies a light beam in the direction of the integrated optical device.

7. Process for the assembly of a first part (2; 38) and at least one second part (4; $28_1 \dots 28_m$; $30_1 \dots 30_n$; 36), whereof one face faces a face of the first part and carries contact studs (10, 12) for connection respectively to contact studs (6, 8) carried by the face of the first part by means of welding elements made from a metallic material with a low welding point and weldable to the contact studs, the surface of each contact stud being wettable by the material in the molten state, whereas its environment is not, comprising the stages of each contact stud of the first part being covered with a wafer (14, 16; $28_1 \ldots 28_m$; $40_1 \ldots 40_p$) of the welding material, which extends over the environment of said contact stud, the wafers having a substantially constant thickness, the contact studs of the second part are placed on the corresponding wafers of the first part, the wafers are raised to a temperature at which they are in the molten state, said wafers having different volumes which, like the thickness of the wafers, the values of the surfaces of the contact studs and the spacing between the contact studs, are chosen in such a way that the face of the second part forms a predetermined angle (1) with the face of the first part when the wafers are heated to said temperature and the temperature is lowered betow the melting point of the welding material.

8. Process according to claim 7, characterized in that the first part (38) comprises at least one row of contact studs and in that on these studs are formed wafers ($40_1 \ldots 40_p$), whose volumes increase from one end of the row to the other and make it possible to obtain the said angle.

9. Process according to claim 7, characterized in that the first part (2) comprises a plurality of parallel rows ($44_1 \ldots 44_k$) of contact studs and in that, for each row, on the studs of said line wafers of the same volume are formed, the volumes of the wafers increasing from one end row to the other end row making it possible to obtain the said angle.

# FIG. 1 A

# FIG. 1 B

EP 0 413 639 B1

FIG. 2 A

FIG. 2 B

FIG. 2 C

11

FIG. 3 A

FIG. 3 B

FIG. 4 A

FIG. 4 B

FIG. 5

FIG. 6 A

FIG. 6 B

FIG. 7